# EUROPÄISCHE PATENTSCHRIFT

(11) **EP 3 724 902 B1**
(45) Veröffentlichungstag und Bekanntmachung des Hinweises auf die Patenterteilung: **07.06.2023**
(21) Anmeldenummer: 18807950.3
(22) Anmeldetag: 21.11.2018
(51) Int. Cl.: H01F 27/36, H01F 37/00, G01R 31/14, G01R 31/333

(54) **DROSSEL UND PRÜFANORDNUNG ZUR DURCHFÜHRUNG VON HOCHSPANNUNGSPRÜFUNGEN**
CHOKE AND TEST ASSEMBLY FOR CARRYING OUT HIGH-VOLTAGE TESTING
BOBINE D'INDUCTANCE ET DISPOSITIF D'ESSAI PERMETTANT LA MISE EN OEUVRE D'ESSAIS À HAUTE TENSION

(30) Priorität: 15.12.2017 DE 102017130182
(43) Veröffentlichungstag der Anmeldung: 21.10.2020
(73) Patentinhaber: Maschinenfabrik Reinhausen GmbH, 93059 Regensburg (DE)
(72) Erfinder: BILINSKI, Enrico, 01129 Dresden (DE); ULLRICH, Clemens, 01259 Dresden (DE); SIEBERT, Günther, 01108 Dresden (DE)
(86) Internationale Anmeldenummer: PCT/EP2018/082110
(87) Internationale Veröffentlichungsnummer: WO 2019/115191

(56) Entgegenhaltungen:
- EP-A1- 0 012 721
- DE-A1-102008 011 802
- DE-B- 1 287 203
- GB-A- 1 005 120
- US-A- 1 811 466

## Beschreibung

Die Erfindung betrifft eine Drossel zur Durchführung von Hochspannungsprüfungen an einem Prüfling sowie eine Prüfanordnung mit wenigstens einer solchen Drossel. Hochspannungsanlagen und Hochspannungskomponenten stellen kapazitive Prüfobjekte dar. Diese kapazitiven Prüfobjekte werden zur Hochspannungsprüfung mit einer oder mehreren Drosseln zu einem Resonanzkreis verbunden, welcher durch eine Einspeisung beispielsweise mit variabler Frequenz versorgt wird. Dabei werden beispielsweise Drosseln mit Luftspulen verwendet, welche in einem Metallgefäß angeordnet sind. In solchen Drosseln kommt es zu einer ungesteuerten Verteilung des magnetischen Flusses, was zu erhöhten Wirbelstromverlusten sowohl in dem Metallgefäß wie auch in elektrisch leitfähigen Bauteilen der Drossel im Inneren des Metallgefäßes führt. Durch diese Wirbelstromverluste wird die Güte des Resonanzkreises reduziert.

Es wird auf das Dokument EP 0012721 A1 verwiesen, welches eine Drosselanordnung für eine Hochspannungprüfanlage gemäß dem Oberbegriff von Anspruch 1 offenbart.

Die Dokumente US 1,811,466 und GB 1,005,120 beziehen sich auf Hochspannungsdrosseln mit zwischen der Spule und einem metallischen Gehäuse angeordneten Flussführungsmitteln zum Führen eines magnetischen Flusses. Das Dokument DE 1 287 203 B bezieht sich auf eine Drossel ohne Eisenkern, wobei die stirnseitigen Enden der Spulen jeweils durch ein Paar von metallischen Abschirmringen umgeben sind, welche einen radialen Abstand von den Spulen aufweisen. Das Dokument DE 10 2008 011 802 A1 bezieht sich auf eine Drosselanordnung mit Teilwicklungen und Schirmkörpern, durch die ein beliebiges Austreten der Felder, welche von den Teilwicklungen der Spule erzeugt werden, verhindert wird.

Es ist daher eine Aufgabe der vorliegenden Erfindung ein verbessertes Konzept für Drosseln zur Durchführung von Hochspannungsprüfungen anzugeben, durch das Wirbelstromverluste reduziert werden.

Diese Aufgabe wird durch den Gegenstand des unabhängigen Anspruchs gelöst. Weitere Ausführungsformen sind Gegenstand der abhängigen Ansprüche.

Das verbesserte Konzept beruht auf der Idee, im Inneren der Drossel ferromagnetisches Material als Flussführungsvorrichtung vorzusehen, durch welches der magnetische Fluss an elektrisch leitfähigen Bauteilen vorbei geführt wird, die andernfalls eine Quelle für erhöhte Wirbelstromverluste sein können.

Gemäß dem verbesserten Konzept wird eine Drossel zur Durchführung von Hochspannungsprüfungen angegeben, welche ein Gehäuse, eine im Inneren des Gehäuses angeordnete Spule, wenigstens ein elektrisch leitfähiges Bauteil und eine Flussführungsvorrichtung zur Führung eines mittels der Spule erzeugbaren magnetischen Flusses aufweist. Das elektrisch leitfähige Bauteil umfasst wenigstens eine Feldsteuerelektrode und ist zwischen der Spule und dem Gehäuse angeordnet. Die Flussführungsvorrichtung umfasst ein ferromagnetisches Material und ist zwischen der Spule und dem wenigstens einen elektrisch leitfähigen Bauteil derart angeordnet, dass der mittels der Spule erzeugbare magnetische Fluss an dem elektrisch leitfähigen Bauteil vorbei geführt oder im Wesentlichen vorbei geführt wird.

Vorbeiführen oder im Wesentlichen Vorbeiführen des magnetischen Flusses an dem elektrisch leitfähigen Bauteil ist dabei so zu verstehen, dass der magnetische Fluss durch das elektrisch leitfähige Bauteil eliminiert oder reduziert wird. Dies wird insbesondere dadurch erreicht, dass die Flussführungsvorrichtung zwischen Spule und elektrisch leitfähigem Bauteil angeordnet ist. Dadurch werden Wirbelströme und entsprechende Wirbelstromverluste in dem elektrisch leitfähigen Bauteil verhindert oder reduziert. Wenn die Drossel in einer Prüfanordnung als Bestandteil eines Resonanzkreises verwendet wird, führt dies letztlich zu einer verbesserten Güte des Resonanzkreises. Dadurch kann die der Prüfanordnung zur Verfügung zu stellende Leistung reduziert werden. Gleichzeitig wird durch den Einsatz des ferromagnetischen Materials die Induktivität der Drossel erhöht, so dass die Baugröße der Drossel bei identischer Induktivität reduziert werden kann bzw. bei identischer Baugröße die Leistungsfähigkeit der Drossel erhöht wird.

Gemäß zumindest einer Ausführungsform umfasst das ferromagnetische Material der Flussführungsvorrichtung oder einzelner Komponenten der Flussführungsvorrichtung ein Elektroblech oder einen Stapel aus Elektroblech oder ein Elektrobandmaterial oder ein amorphes ferromagnetisches Material.

Gemäß zumindest einer Ausführungsform besteht das Gehäuse wenigstens zum Teil aus elektrisch leitfähigem Material, beispielsweise Metall. Die Flussführungsvorrichtung ist derart angeordnet, dass sie das elektrisch leitfähige Material des Gehäuses von einem mittels der Spule erzeugbaren magnetischen Fluss abschirmt.

Gemäß zumindest einer Ausführungsform besteht das Gehäuse wenigstens zum Teil aus Stahl. Beispielsweise kann eine Gehäusewand des Gehäuses vollständig aus Stahl bestehen.

Durch die Abschirmung des Gehäuses von dem Fluss werden Wirbelstromverluste in dem Gehäuse reduziert. Dies ermöglicht es, auf kostenintensive Materialen mit besonders hoher elektrischer Leitfähigkeit, wie zum Beispiel Aluminium, zu verzichten und stattdessen kostengünstige Materialien wie Stahl zu verwenden. Zudem kann die Wandstärke des Gehäusematerials verringert werden, ohne dass dadurch durch Wirbelstromverluste verursachte thermische Auswirkungen ein technisch verträgliches Maß übersteigen.

Gemäß zumindest einer Ausführungsform umfasst die Flussführungsvorrichtung eine zylindrische, insbesondere kreiszylindrische, Komponente, welche die Spule radial zumindest teilweise umschließt. Radial umschließen bedeutet dabei in einer Ebene senkrecht zur Wickelachse der Spule umschließen. In axialer, also zur Wickelachse paralleler, Richtung kann die Spule über die zylindrische Komponente hinausragen oder mit der zylindrischen Komponente abschließen. Alternativ kann die zylindrische Komponente axial über die Spule hinausragen.

Gemäß zumindest einer Ausführungsform umschließt die zylindrische Komponente die Spule radial vollständig.

Gemäß zumindest einer Ausführungsform besteht die zylindrische Komponente wenigstens zum Teil aus einem ferromagnetischen Material.

Gemäß zumindest einer Ausführungsform umfasst die Flussführungsvorrichtung wenigstens zwei Segmente, die radial um die Spule herum verteilt, beispielsweise gleichverteilt, angeordnet sind und sich axial, beispielsweise vollständig oder im Wesentlichen vollständig, entlang der Spule erstrecken. Anzahl und Abmessungen der Segmente können dabei derart sein, dass die Segmente gemeinsam die Spule radial vollständig oder teilweise umschließen.

Gemäß zumindest einer Ausführungsform sind die Segmente stabförmig oder quaderförmig oder als Abschnitte eines Hohlzylinders, insbesondere hohlen Kreiszylinders, ausgebildet.

Gemäß zumindest einer Ausführungsform bestehen die Segmente jeweils wenigstens zum Teil aus einem ferromagnetischen Material.

Gemäß zumindest einer Ausführungsform ist die Flussführungsvorrichtung elektrisch und mechanisch mit der Spule verbunden. Dadurch liegen die Flussführungsvorrichtung und die Spule auf demselben elektrischen Potential.

Gemäß zumindest einer Ausführungsform ist das Gehäuse von der Flussführungsvorrichtung und von der Spule elektrisch isoliert.

Gemäß zumindest einer Ausführungsform werden die Flussführungsvorrichtung oder die zylindrische Komponente oder die Segmente von der Spule getragen und/oder liegen auf der Spule auf. Dadurch wird eine besonders kompakte Bauweise der Drossel erreicht.

Gemäß zumindest einer Ausführungsform ist die Flussführungsvorrichtung oder die zylindrische Komponente oder sind die Segmente mittels Stellschrauben mit der Spule verbunden. Insbesondere kann dadurch ein Spalt zwischen Flussführungsvorrichtung oder zylindrische Komponente oder Segmenten und Spule erzielt werden um fertigungsbedingte Toleranzen auszugleichen.

Gemäß der Erfindung nach Anspruch 1 umfasst das wenigstens eine elektrische Bauteil wenigstens eine Feldsteuerelektrode.

Gehäuse und Flussführungsvorrichtung liegen währen einer Hochspannungsprüfung auf unterschiedlichen elektrischen Potentialen. Die Feldsteuerelektrode stellt dementsprechend einen Schirmkörper dar, der dazu dient, das Auftreten von Höchstfeldstärken an Ecken, Kanten oder Oberflächen mit geringem Krümmungsradius zu verhindern und damit erforderliche Schlagweiten im Inneren der Drossel, insbesondere erforderliche Abstände zwischen Spule und Gehäuse oder Flussführungsvorrichtung und Gehäuse, zu reduzieren.

Gemäß zumindest einer Ausführungsform ist das elektrisch leitfähige Bauteil oder die Feldsteuerelektrode zwischen der Flussführungsvorrichtung und dem Gehäuse angeordnet, insbesondere radial zwischen der Flussführungsvorrichtung und dem Gehäuse. Gemäß zumindest einer Ausführungsform ist die Feldsteuerelektrode an einem stirnseitigen Ende der zylindrischen Komponente oder der Segmente angeordnet.

Gemäß zumindest einer Ausführungsform umfasst das wenigstens eine elektrische Bauteil eine oder mehrere weitere Feldsteuerelektroden.

Gemäß zumindest einer Ausführungsform ist eine der weiteren Feldsteuerelektrode an einem weiteren stirnseitigen Ende der zylindrischen Komponente oder der Segmente angeordnet.

Gemäß zumindest einer Ausführungsform weist die Feldsteuerelektrode eine ringförmige Struktur auf und ist koaxial zur Wickelachse der Spule ausgerichtet.

Gemäß zumindest einer Ausführungsform besteht die Feldsteuerelektrode teilweise oder vollständig aus Metall. Insbesondere weist die Feldsteuerelektrode einen Metallkörper auf. Insbesondere ist die Feldsteuerelektrode nicht aus einem elektrisch isolierenden Körper mit einer elektrisch leitfähigen Beschichtung gefertigt.

Durch das Vorbeiführen des magnetischen Flusses an der Feldsteuerelektrode mittels der Flussführungsvorrichtung und die dadurch reduzierten Wirbelströme in der Feldsteuerelektrode kann die Konstruktion mit Metallkörper verwendet werden. Dies hat gegenüber der Verwendung von Kunststoffkörpern mit leitfähiger Beschichtung, beispielsweise einer Beschichtung aus Halbleitermaterial, einerseits einen Kostenvorteil. Des Weiteren kann die Feldsteuerelektrode mit Metallkörper eine Oberfläche mit geringerer Rauigkeit besitzen, beispielsweise eine polierte Oberfläche, und damit zu geringeren Höchstfeldstärken führen. Daher werden die erforderlichen Schlagweiten im Inneren der Drossel reduziert und damit eine kompaktere Bauform ermöglicht.

Gemäß zumindest einer Ausführungsform umfasst die Drossel eine Aufhängung, insbesondere eine zentrale Aufhängung, welche die Spule trägt.

Gemäß zumindest einer Ausführungsform besteht die Aufhängung aus elektrisch nicht leitfähigem Material.

Gemäß zumindest einer Ausführungsform ist die Aufhängung koaxial zur Wickelachse der Spule ausgerichtet.

Gemäß zumindest einer Ausführungsform umfasst die Aufhängung einen oder mehrere mechanisch miteinander verbundene Träger.

Gemäß zumindest einer Ausführungsform umfasst die Flussführungsvorrichtung eine innere Komponente, welche im Inneren der Aufhängung angeordnet ist. Insbesondere besteht die innere Komponente zumindest zum Teil aus ferromagnetischem Material. Dadurch wird die Induktivität der Drossel weiter erhöht.

Gemäß zumindest einer Ausführungsform umfasst die Flussführungsvorrichtung wenigstens eine stirnseitige Komponente, welche an einem stirnseitigen Ende der Spule angeordnet ist und senkrecht zu der Wickelachse der Spule ausgerichtet ist. Insbesondere besteht die stirnseitige Komponente zumindest zum Teil aus ferromagnetischem Material. Dadurch werden stirnseitig von der Spule liegende Teile des Gehäuses oder entsprechend angeordnete elektrisch leitfähige Bauteile der Drossel von dem magnetischen Fluss abgeschirmt.

Gemäß zumindest einer Ausführungsform ist die stirnseitige Komponente mit der zylindrischen Komponente oder mit wenigstens einem der Segmente verbunden.

Gemäß zumindest einer Ausführungsform umfasst die Drossel wenigstens eine weitere Spule, welche mit der Spule in Reihe geschaltet ist.

Gemäß zumindest einer Ausführungsform haben die Spule und die wenigstens eine weitere Spule dieselbe Wickelachse und sind axial nebeneinander oder radial übereinander angeordnet, insbesondere auf der Aufhängung.

Gemäß zumindest einer Ausführungsform ist die Spule als Luftspule, also als Spule ohne ferromagnetischen Kern, ausgebildet. Umfasst die Drossel eine weitere Spule axial neben der Spule, so ist auch diese als Luftspule ausgebildet. Der Begriff Luftspule schließt dabei nicht aus, dass statt oder neben Luft andere, nicht ferromagnetische Materialen, insbesondere Isoliermedien, im Gehäuse und im Inneren der Spule vorhanden sind.

Die Spule und die weitere Spulen können beispielsweise derart gewickelt sein, dass axial benachbarte Spulen an deren radialer Innenseite jeweils unterschiedliche Potentiale, insbesondere Hochspannungspotentiale, aufweisen. Daher weisen diese Spulen entsprechende Abstände axiale voneinander auf, um die erforderliche elektrische Durchschlagsfestigkeit sicherzustellen. Durch die Ausbildung als Luftspulen wird sichergestellt, dass diese Abstände nicht überbrückt werden.

Gemäß zumindest einer Ausführungsform weist die Drossel einen Hochspannungsanschluss zur elektrischen Kontaktierung der Spule, insbesondere eines ersten Kontakts der Spule, auf. Der Hochspannungsanschluss kann dabei zum Beispiel zum Anschluss des Prüflings dienen.

Gemäß zumindest einer Ausführungsform umfasst der Hochspannungsanschluss eine Hochspannungsdurchführung.

Gemäß zumindest einer Ausführungsform weist die Drossel einen weiteren Spannungsanschluss, insbesondere weiteren Hochspannungsanschluss auf, der eine Durchführung, insbesondere weitere Hochspannungsdurchführung, umfasst.

In wenigstens einer Ausführung, in der die Drossel nur eine Spule aufweist, dient der weitere Spannungsanschluss zum elektrischen Anschluss eines zweiten Kontakts der Spule.

In wenigstens einer Ausführung, in der die Drossel die Spule und eine weitere Spule aufweist, dient der weitere Spannungsanschluss zum elektrischen Anschluss der weiteren Spule.

Gemäß zumindest einer Ausführungsform ist die Aufhängung an der Hochspannungsdurchführung und/oder der weiteren Durchführung befestigt.

Gemäß zumindest einer Ausführungsform sind die Hochspannungsdurchführung und die weitere Durchführung an gegenüberliegenden Seiten des Gehäuses angeordnet.

Gemäß zumindest einer Ausführungsform ist die Drossel als Drossel mit fester, insbesondere nicht veränderbarer, Induktivität ausgebildet.

Gemäß zumindest einer Ausführungsform ist der Innenraum des Gehäuses mit einem Isoliermedium, insbesondere einem nicht leitfähigem Fluid, beispielsweise einer Isolierflüssigkeit oder einem Isoliergas gefüllt.

Gemäß zumindest einer Ausführungsform steht das Isoliermedium unter einem gegenüber dem Umgebungsdruck erhöhtem Druck. Dadurch können erforderliche elektrische Schlagweiten reduziert werden, was zu einer kompakteren Bauform beiträgt.

Gemäß dem verbesserten Konzept wird auch eine Prüfanordnung zur Durchführung von Hochspannungsprüfungen an einem Prüfling angegeben. Die Prüfanordnung weist eine Drossel gemäß dem verbesserten Konzept auf.

Gemäß zumindest einer Ausführungsform ist das Gehäuse der Drossel geerdet.

Gemäß zumindest einer Ausführungsform umfasst die Prüfanordnung eine Einspeisequelle, welche mit der Drossel und dem Prüfling zu einem Resonanzkreis verbindbar oder verbunden ist. Dabei ist die Drossel zwischen Einspeisequelle und Prüfling angeordnet. Insbesondere ist der Hochspannungsanschluss mit dem Prüfling verbindbar oder verbunden und der weitere Spannungsanschluss ist mit der Einspeisequelle verbindbar oder verbunden.

Gemäß zumindest einer Ausführungsform ist die Einspeisequelle ist als Spannungsquelle mit variabler Frequenz ausgebildet.

Gemäß zumindest einer Ausführungsform weist die Prüfanordnung eine oder mehrere weitere Drosseln auf, die mit der Drossel in Reihe oder parallel geschaltet sind. In solchen Ausführungsformen ist der weitere Spannungsanschluss der Drossel direkt oder über die weiteren Drosseln mit der Einspeisequelle verbindbar oder verbunden. Die weiteren Drosseln oder einzelne der weiteren Drosseln können gemäß dem verbesserten Konzept ausgebildet sein.

Gemäß zumindest einer Ausführungsform umfasst die Prüfanordnung den Prüfling.

Gemäß zumindest einer Ausführungsform ist der Resonanzkreis ein Serienresonanzkreis oder ein Parallelresonanzkreis.

Im Folgenden wird die Erfindung anhand beispielhafter Ausführungsformen unter Bezug auf die Zeichnungen im Detail erklärt. Komponenten, die funktionell identisch sind oder einen identischen Effekt haben, können mit identischen Bezugszeichen versehen sein. Identische Komponenten oder Komponenten mit identischer Funktion sind unter Umständen nur bezüglich der Figur erklärt, in der sie zuerst erscheinen. Die Erklärung wird nicht notwendigerweise in den darauffolgenden Figuren wiederholt.

Es zeigen
- Figur 1: ein Blockschaltbild einer beispielhaften Ausführungsform einer Prüfanordnung mit einer Drossel gemäß dem verbesserten Konzept;
- Figur 2: eine Schnittdarstellung einer beispielhaften Ausführungsform einer Drossel gemäß dem verbesserten Konzept; und
- Figur 3: eine Schnittdarstellung einer weiteren beispielhaften Ausführungsform einer Drossel gemäß dem verbesserten Konzept.

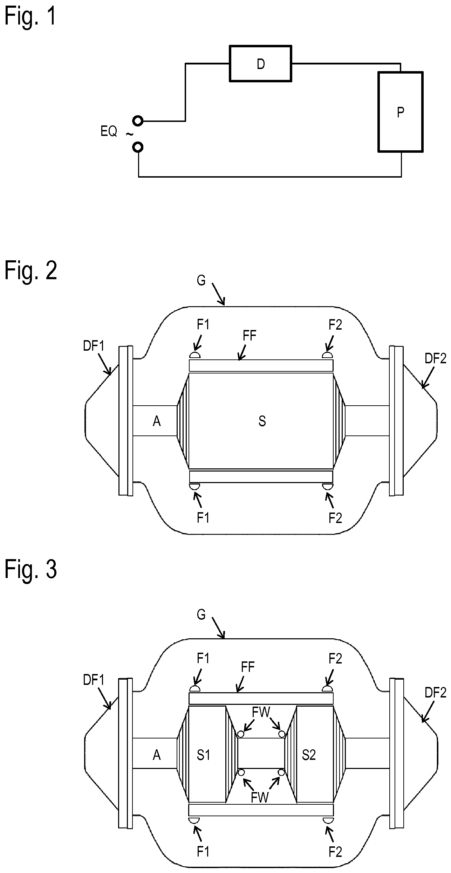

Figur 1 zeigt ein Blockschaltbild einer beispielhaften Ausführungsform einer Prüfanordnung mit einer Drossel gemäß dem verbesserten Konzept, insbesondere eines Serienresonanzkreises.

Die Prüfanordnung umfasst eine Einspeisequelle EQ, die als Wechselspannungsquelle ausgebildet ist, eine Drossel D gemäß dem verbesserten Konzept, sowie einen mit der Drossel D in Reihe geschalteten Prüfling P mit einer Prüflingskapazität. Optional können in dem Resonanzkreis eine oder mehrere weitere Prüfdrosseln mit der Drossel D in Reihe und/oder parallel geschaltet sein, die beispielsweise ausgeführt sind wie die Drossel D. Des Weiteren kann der Resonanzkreis weitere nicht gezeigte Komponenten umfassen.

Die Einspeisequelle EQ ist beispielsweise mit einer Spule der Drossel D verbunden. Im Betrieb wird eine Erregerspannung, insbesondere eine Wechselspannung, von der Einspeisequelle EQ bereitgestellt, die über Drossel D und Prüfling P abfällt. Im Resonanzfall fällt über dem Prüfling P eine Prüfspannung ab, deren Betrag größer ist als der der Erregerspannung, so dass es zu einer Spannungsüberhöhung kommt. Die Güte des Resonanzkreises, also das Verhältnis von Prüfblindleistung zu Verlustleistung des Resonanzkreises, entspricht dem Verhältnis der Prüfspannung zur Erregerspannung. Verschiedene Ausführungsformen der Drossel D werden nun bezüglich der Figuren 2 und 3 genauer beschrieben.

Figur 2 zeigt eine beispielhafte Ausführungsform einer Drossel gemäß dem verbesserten Konzept.

Die Drossel hat ein Gehäuse G, das zumindest zum Teil aus Metall besteht, beispielsweise aus Stahl. In einem Resonanzkreis ist das Gehäuse beispielsweise geerdet. Die Drossel weist eine zentrale Aufhängung A auf, um die herum eine Spule S angeordnet ist. Die Drossel weist außerdem erste und eine zweite Durchführung DF1, DF2 auf, wobei wenigstens die erste Durchführung DF1 als Hochspannungsdurchführung ausgebildet ist. Die erste Durchführung DF1 dient beispielsweise zum Anschluss des Prüflings P in einer Anordnung wie in Figur 1 gezeigt. Die zweite Durchführung DF2 dient beispielsweise zum Anschluss der Einspeisequelle EQ in einer Anordnung wie in Figur 1 gezeigt oder zum Anschluss einer weiteren Drossel (nicht gezeigt). Die Aufhängung ist beispielsweise an dem Gehäuse G und/oder an einer oder beiden Aufhängungen DF1, DF2 befestigt.

Die Drossel weist eine Flussführungsvorrichtung FF zur Führung eines mittels der Spule S erzeugbaren magnetischen Flusses. Die Flussführungsvorrichtung FF enthält oder besteht aus ferromagnetischem Material. Im abgebildeten Beispiel besteht die Flussführungsvorrichtung FF aus einer zylindrischen Komponente, welche die Spule S in radialer Richtung vollständig umgibt oder aus mehreren, beispielsweise vier, Segmenten, welche die Spule S in radialer Richtung teilweise oder vollständig umgeben.

Zudem weist die Drossel beispielsweise zwei Feldsteuerelektroden F1, F2 auf, die jeweils an einem stirnseitigen Ende der zylindrischen Komponente zwischen Flussführungsvorrichtung FF und Gehäuse G angeordnet sind. Die Feldsteuerelektroden F1, F2 sind beispielsweise ringförmig ausgebildet und umgeben die zylindrische Komponente radial. Die Feldsteuerelektroden F1, F2 dienen zur Abschirmung beziehungsweise Vermeidung von Höchstfeldstärken zwischen Flussführungsvorrichtung FF und Gehäuse G. Ohne Feldsteuerelektroden müssten die Abstände zwischen Gehäuse G und Flussführungsvorrichtung FF erhöht werden um elektrische Entladungen sicher zu verhindern.

Die zylindrische Komponente oder die Segmente der Flussführungsvorrichtung FF sind zwischen der Spule S und den Feldsteuerelektroden F1, F2 angeordnet. Demzufolge werden durch die Flussführungsvorrichtung FF magnetische Streuflüsse durch das Gehäuse G wie auch durch die Feldsteuerelektroden F1, F2 reduziert oder verhindert. Durch den so gesteuerten magnetischen Fluss werden Wirbelströme im Gehäuse G und den Feldsteuerelektroden F1, F2 reduziert. Durch diese Konstruktion wird es möglich, kompakte Drosseln beispielsweise mit einem Stahlgehäuse auszustatten. Auch die Feldsteuerelektroden F1, F2 können aus ganz oder teilweise aus Metall gefertigt sein, eine aufwändige Herstellung aus leitfähig beschichteten Kunststoffen ist nicht erforderlich.

Figur 3 zeigt eine weitere beispielhafte Ausführungsform einer Drossel gemäß dem verbesserten Konzept. Die Ausführungsform der Figur 3 beruht auf der Ausführungsform der Figur 2.

Im Unterschied zu der Ausführungsform aus Figur 2 weist die Drossel aus Figur 3 anstelle der Spule S zwei in Serie geschaltete Spulen S1 und S2 auf, die axial nebeneinander auf der Aufhängung A angeordnet sind. Anders ausgedrückt wird eine Spule mit zwei in Serie geschalteten Teilwicklungen S1, S2 verwendet. In alternativen Ausführungsformen können die beiden Spulen S1, S2 radial übereinander angeordnet sein.

Optional sind weitere Feldsteuerelektroden FW vorgesehen, die zwischen den einander zugewandten Enden der Spulen S1, S2 angeordnet sind um die elektrische Höchstfeldstärke zwischen beiden Spulen S1, S2 zu reduzieren und damit deren Abstand zueinander reduzieren zu können, was zu einer kompakten Bauform beiträgt. Die weitere Feldsteuerelektroden FW sind beispielsweise ringförmig ausgebildet und umgeben die Aufhängung A radial.

Durch eine Drossel nach dem verbesserten Konzept werden Wirbelstromverluste im Drosselgehäuse wie auch in elektrisch leitfähigen Bauteilen der Drossel reduziert. Insbesondere können für Gehäuse oder die elektrisch leitfähigen Bauteile kostengünstige Materialien eingesetzt und eine besonders kompakte Bauform der Drossel erreicht werden, da wegen der reduzierten Wirbelstromverluste eine höherer elektrische Widerstand des Gehäuses oder der elektrisch leitfähigen Bauteile weniger stark ins Gewicht fällt. Entsprechend können gleicher Baugröße leistungsstärkere Drosseln gebaut werden. Durch geringere Wirbelstromverluste wird die Güte eines Resonanzkreises, in dem die Drossel eingesetzt wird, erhöht. Der Leistungsbedarf der Einspeisung ist dadurch reduziert. Durch die Reduzierung der Leistung der Einspeisung können andere in der Prüfanordnung integrierte Komponenten bezüglich ihrer Leistung und Baugröße verkleinert werden.

### BEZUGSZEICHEN

- D: Drossel
- P: Prüfling
- EQ: Einspeisequelle
- G: Gehäuse
- A: Aufhängung
- FF: Flussführungsvorrichtung
- S, S1,S2: Spulen
- F1, F2, FW: Feldsteuerelektroden
- DF1, DF2: Durchführungen

## Patentansprüche

1. Drossel zur Durchführung von Hochspannungsprüfungen umfassend
- ein Gehäuse (G);
- eine im Inneren des Gehäuses (G) angeordnete Spule (S);
- wenigstens ein zwischen der Spule (S) und dem Gehäuse (G) angeordnetes elektrisch leitfähiges Bauteil (F1, F2), das wenigstens eine Feldsteuerelektrode (F1, F2) umfasst; und
- eine Flussführungsvorrichtung (FF) zur Führung eines mittels der Spule (S) erzeugbaren magnetischen Flusses, wobei die Flussführungsvorrichtung (FF)
- ein ferromagnetisches Material enthält; **dadurch gekennzeichnet, dass** die Flussführungsvorrichtung zwischen der Spule (S) und dem wenigstens einen elektrisch leitfähigen Bauteil (F1, F2) derart angeordnet ist, dass der mittels der Spule (S) erzeugbare magnetische Fluss an dem elektrisch leitfähigen Bauteil (F1, F2) vorbei geführt wird.

2. Drossel nach Anspruch 1, wobei das Gehäuse (G) wenigstens zum Teil aus elektrisch leitfähigem Material besteht und die Flussführungsvorrichtung (FF) derart angeordnet ist, dass sie das elektrisch leitfähige Material des Gehäuses (G) von einem mittels der Spule (S) erzeugbaren magnetischen Fluss abschirmt.

3. Drossel nach einem der Ansprüche 1 oder 2, wobei die Flussführungsvorrichtung (FF) eine zylindrische Komponente umfasst, welche die Spule (S) radial zumindest teilweise umschließt.

4. Drossel nach einem der Ansprüche 1 oder 2, wobei die Flussführungsvorrichtung (FF) wenigstens zwei Segmente umfasst, welche radial um die Spule (S) herum verteilt angeordnet sind und sich entlang der Spule (S) erstrecken.

5. Drossel nach einem der Ansprüche 1 bis 4, wobei die Flussführungsvorrichtung (FF) elektrisch und mechanisch mit der Spule (S) verbunden ist.

6. Drossel nach einem der Ansprüche 1 bis 5, wobei das elektrisch leitfähige Bauteil (F1, F2) zwischen der Flussführungsvorrichtung (FF) und dem Gehäuse (G) angeordnet ist, insbesondere radial zwischen der Flussführungsvorrichtung (FF) und dem Gehäuse (G).

7. Drossel nach einem der Ansprüche 1 bis 6, wobei die Spule (S) als Luftspule ausgebildet ist.

8. Drossel nach einem der Ansprüche 1 bis 6, wobei die Drossel (D) eine Aufhängung (A) umfasst, welche die Spule (S) trägt und die Flussführungsvorrichtung (FF) eine innere Komponente umfasst, welche im Inneren der Aufhängung (A) angeordnet ist.

9. Drossel nach einem der Ansprüche 1 bis 8, wobei die Flussführungsvorrichtung (FF) wenigstens eine stirnseitige Komponente umfasst, welche an einem stirnseitigen Ende der Spule (S) angeordnet ist und senkrecht zu einer Wickelachse der Spule (S) ausgerichtet ist.

10. Drossel nach einem der Ansprüche 1 bis 9, wobei die Drossel (D) wenigstens eine weitere Spule (S2) umfasst, welche mit der Spule (S1) in Reihe geschaltet ist.

11. Drossel nach einem der Ansprüche 1 bis 10, wobei die Drossel (D) wenigstens einen Hochspannungsanschluss (DF1) zur elektrischen Kontaktierung der Spule (S) aufweist.

12. Drossel nach einem der Ansprüche 1 bis 11, wobei die Drossel (D) als Drossel mit fester Induktivität ausgebildet ist.

13. Prüfanordnung zur Durchführung von Hochspannungsprüfungen an einem Prüfling (P), wobei die Prüfanordnung eine oder mehrere in Reihe oder parallel geschaltete Drosseln aufweist, wobei wenigstens eine der Drosseln gemäß einem der Ansprüche 1 bis 12 ausgebildet ist.

14. Prüfanordnung nach Anspruch 13, wobei die Prüfanordnung eine Einspeisequelle (EQ) umfasst, welche mit der einen oder den mehreren Drosseln und dem Prüfling (P) zu einem Resonanzkreis verbindbar ist.

## Claims

1. Choke for carrying out high-voltage tests, comprising
- a housing (G);
- a coil (S) arranged in the interior of the housing (G);
- at least one electrically conductive component (F1, F2) arranged between the coil (S) and the housing (G), which comprises at least a field control electrode (F1, F2).; and
- a flux guiding device (FF) for guiding a magnetic flux able to be generated by means of the coil (S), wherein the flux guiding device (FF)
- contains a ferromagnetic material;
**characterized in that**
- the flux guiding device (FF) is arranged between the coil (S) and the at least one electrically conductive component (F1, F2) in such a way that the magnetic flux able to be generated by means of the coil (S) is guided past the electrically conductive component (F1, F2).

2. Choke according to claim 1, wherein the housing (G) consists at least in part of electrically conductive material and the flux guiding device (FF) is so arranged that it screens the electrically conductive material of the housing (G) from a magnetic flux able to be generated by means of the coil (S).

3. Choke according to one of claims 1 and 2, wherein the flux guiding device (FF) comprises a cylindrical component which at least partly radially surrounds the coil (S).

4. Choke according to one of claims 1 and 2, wherein the flux guiding device (FF) comprise at least two segments which are arranged to be distributed radially around the coil (S) and which extend along the coil (S).

5. Choke according to any one of claims 1 to 4, wherein the flux guiding device (FF) is electrically and mechanically connected with the coil (S).

6. Choke according to any one of claims 1 to 5, wherein the electrically conductive component (F1, F2) is arranged between the flux guiding device (FF) and the housing (G), in particular radially between the flux guiding device (FF) and the housing (G).

7. Choke according to any one of claims 1 to 6, wherein the coil (S) is constructed as an air coil.

8. Choke according to any one of claims 1 to 6, wherein the choke (D) comprises a suspension (A), which carries the coil (S), and the flux guiding device (FF) comprises an inner component arranged in the interior of the suspension (A).

9. Choke according to any one of claims 1 to 8, wherein the flux guiding device (FF) comprises at least one end component which is arranged at a face end of the coil (S) and is oriented perpendicularly to a winding axis of the coil (S).

10. Choke according to any one of claims 1 to 9, wherein the choke (D) comprises at least one further coil (S2), which is connected in series with the coil (S1).

11. Choke according to any one of claims 1 to 10, wherein the choke (D) comprises at least one high-voltage terminal (DF1) for electrical contacting of the coil (S).

12. Choke according to any one of claims 1 to 11, wherein the choke (D) is constructed as a choke with fixed inductance.

13. Test arrangement for carrying out high-voltage tests on a test piece (P), wherein the test arrangement comprises one or more chokes connected in series or parallel, wherein at least one of the chokes is constructed in accordance with any one of claims 1 to 12.

14. Test arrangement according to claim 13, wherein the test arrangement comprises a feed source (EQ), which is connectible with the one or more chokes and the test piece (P) to form a resonance circuit.

## Revendications

1. Self pour la mise en œuvre d'essais à haute tension comprenant
- un boîtier (G) ;
- une bobine (S) agencée à l'intérieur du boîtier (G) ;
- au moins un composant électriquement conducteur (F1, F2) agencé entre la bobine (S) et le boîtier (G), qui comprend au moins une électrode de commande de champ (F1, F2) ; et
- un dispositif de guidage de flux (FF) pour guider un flux magnétique pouvant être généré au moyen de la bobine (S), le dispositif de guidage de flux (FF) contenant
- un matériau ferromagnétique ; **caractérisée en ce que** le dispositif de guidage de flux est agencé entre la bobine (S) et l'au moins un composant électriquement conducteur (F1, F2) de telle sorte que le flux magnétique pouvant être généré au moyen de la bobine (S) est guidé devant le composant électriquement conducteur (F1, F2).

2. Self selon la revendication 1, dans lequel le boîtier (G) est au moins partiellement constitué de matériau électriquement conducteur et le dispositif de guidage de flux (FF) est agencé de telle sorte qu'il protège le matériau électriquement conducteur du boîtier (G) d'un flux magnétique pouvant être généré au moyen de la bobine (S).

3. Self selon l'une quelconque des revendications 1 ou 2, dans lequel le dispositif de guidage de flux (FF) comprend un composant cylindrique qui entoure radialement au moins partiellement la bobine (S).

4. Self selon l'une quelconque des revendications 1 ou 2, dans lequel le dispositif de guidage de flux (FF) comprend au moins deux segments qui sont répartis radialement autour de la bobine (S) et s'étendent le long de la bobine (S).

5. Self selon l'une quelconque des revendications 1 à 4, dans lequel le dispositif de guidage de flux (FF) est relié électriquement et mécaniquement à la bobine (S).

6. Self selon l'une quelconque des revendications 1 à 5, dans lequel le composant électriquement conducteur (F1, F2) est agencé entre le dispositif de guidage de flux (FF) et le boîtier (G), notamment radialement entre le dispositif de guidage de flux (FF) et le boîtier (G).

7. Self selon l'une quelconque des revendications 1 à 6, dans lequel la bobine (S) est configurée sous forme de bobine à air.

8. Self selon l'une quelconque des revendications 1 à 6, dans lequel le self (D) comprend une suspension (A) qui supporte la bobine (S) et le dispositif de guidage de flux (FF) comprend un composant intérieur qui est agencé à l'intérieur de la suspension (A).

9. Self selon l'une quelconque des revendications 1 à 8, dans lequel le dispositif de guidage de flux (FF) comprend au moins un composant frontal qui est agencé à une extrémité frontale de la bobine (S) et qui est orienté perpendiculairement à un axe d'enroulement de la bobine (S) .

10. Self selon l'une quelconque des revendications 1 à 9, dans lequel le self (D) comprend au moins une autre bobine (S2) qui est connectée en série à la bobine (S1).

11. Self selon l'une quelconque des revendications 1 à 10, dans lequel le self (D) présente au moins une connexion haute tension (DF1) pour la mise en contact électrique de la bobine (S).

12. Self selon l'une quelconque des revendications 1 à 11, dans lequel le self (D) est configuré sous forme de self à inductance fixe.

13. Agencement d'essais pour la mise en œuvre d'essais à haute tension sur une pièce testée (P), l'agencement d'essais présentant un ou plusieurs selfs connectés en série ou en parallèle, au moins l'un des selfs étant configuré selon l'une quelconque des revendications 1 à 12.

14. Agencement d'essais selon la revendication 13, dans lequel l'agencement d'essais comprend une source d'alimentation (EQ) qui peut être reliée au self ou aux plusieurs selfs et à la pièce testée (P) pour former un circuit résonant.
